Europäisches Patentamt

European Patent Office

Office européen des brevets

(19)

(11) Veröffentlichungsnummer : **0 045 447**
**B1**

(12)

# EUROPÄISCHE PATENTSCHRIFT

(45) Veröffentlichungstag der Patentschrift :
21.11.85

(21) Anmeldenummer : 81105803.1

(22) Anmeldetag : 22.07.81

(51) Int. Cl.⁴ : **H 01 L 29/72, H 01 L 29/06**

(54) Transistoranordnung mit hoher Kollektor-Emitter-Durchbruchsspannung.

(30) Priorität : 04.08.80 DE 3029553

(43) Veröffentlichungstag der Anmeldung :
10.02.82 Patentblatt 82/06

(45) Bekanntmachung des Hinweises auf die Patenterteilung : 21.11.85 Patentblatt 85/47

(84) Benannte Vertragsstaaten :
DE FR GB IT

(56) Entgegenhaltungen :
DE-A- 2 710 878
US-A- 4 151 540

(73) Patentinhaber : **Siemens Aktiengesellschaft
Berlin und München Wittelsbacherplatz 2
D-8000 München 2 (DE)**

(72) Erfinder : **Werner, Wolfgang, Dr.
Lorenzonistrasse 66
D-8000 München 90 (DE)**

EP 0 045 447 B1

## Beschreibung

Die Erfindung betrifft eine Transistoranordnung mit hoher Kollektor-Emitter-Durchbruchsspannung gemäß dem Oberbegriff des Anspruchs 1. Eine solche Transistoranordnung ist aus US-A-4 151 540 bekannt.

Die I²L-Technologie ist infolge ihrer Kompatibilität mit der Bipolar-Technologie hervorragend geeignet zur Integration von analogen und digitalen Funktionen innerhalb eines Schaltkreises. Dabei werden wichtige elektrische Parameter, wie zum Beispiel Fanout und Schaltgeschwindigkeit, mit abnehmender Dicke der auf dem Substrat des Schaltkreises vorgesehenen epitaktischen Schicht besser. Geringere Dicken der epitaktischen Schicht führen aber auch zu niedrigen Kollektor-Basis- beziehungsweise Kollektor-Emitter-Durchbruchsspannungen, was für die Verwirklichung vieler analoger Funktionen einen erheblichen Nachteil bedeutet. Für eine Dicke der epitaktischen Schicht von 3 μm ergibt sich beispielsweise eine Kollektor-Basis-Durchbruchsspannung von 30 V und eine Kollektor-Emitter-Durchbruchsspannung von 5 bis 10 V.

Höhere Werte für die Kollektor-Emitter-Durchbruchsspannung werden gewöhnlich entweder durch eine viel Fläche benötigende Reihenschaltung von NPN-Transistoren oder mittels der Anwendung der sogenannten Blauschild-Diode (vergleiche R. A. Blauschild, « High-Voltage Analog Performance with Low-Voltage Digital Devices », IEEE Journal or Solid-State Circuits, Volume SC-13, No. 6, December 1978) erreicht.

Eine andere Möglichkeit, hohe Kollektor-Emitter-Durchbruchsspannungen zu erreichen, besteht in der Verwendung von Prozessen mit sehr hohen Epitaxiedicken (8 bis 15 μm) und sehr niedrigen Dotierungen (1 bis 6 · 10¹⁵ cm⁻³) der Epitaxieschicht. Mit diesen Prozessen lassen sich jedoch keine schnellen Digitalschaltungen (ECL, ITL, I²L, ISL) realisieren. Außerdem sind die lateralen Abmessungen der Bauelemente naturgemäß erheblich größer (Packungsdichte) als bei dem hier verwendeten Prozeß mit einer Epitaxiedicke von nur 2 bis 3 μm (vergleiche Leif Halbo and Trond A. Hansen, « I²L and high voltage analog circuits on the same chip : A comparison between various combination processes », IEEE Journal of Solid-State-Circuits, SC-14, No. 4, 666 bis 671 (1979)).

Es ist daher Aufgabe der Erfindung, eine Transistoranordnung der eingangs genannten Art anzugeben, die sich durch eine hohe Kollektor-Emitter-Durchbruchsspannung beziehungsweise Kollektor-Basis-Durchbruchsspannung auszeichnet und für einen bestimmten Kollektorstrom einen wesentlich geringeren Platzbedarf als bestehende Transistoranordnungen erfordert und die außerdem die Realisierung von sehr schnellen Digitalschaltungen (ECL, LSTTL, HSTTL, I²L, ISL) ermöglicht, was mit den bisher bekannten Techniken nicht möglich ist.

Diese Aufgabe wird durch die Merkmale des kennzeichnenden Teils des Anspruchs 1 gelöst.

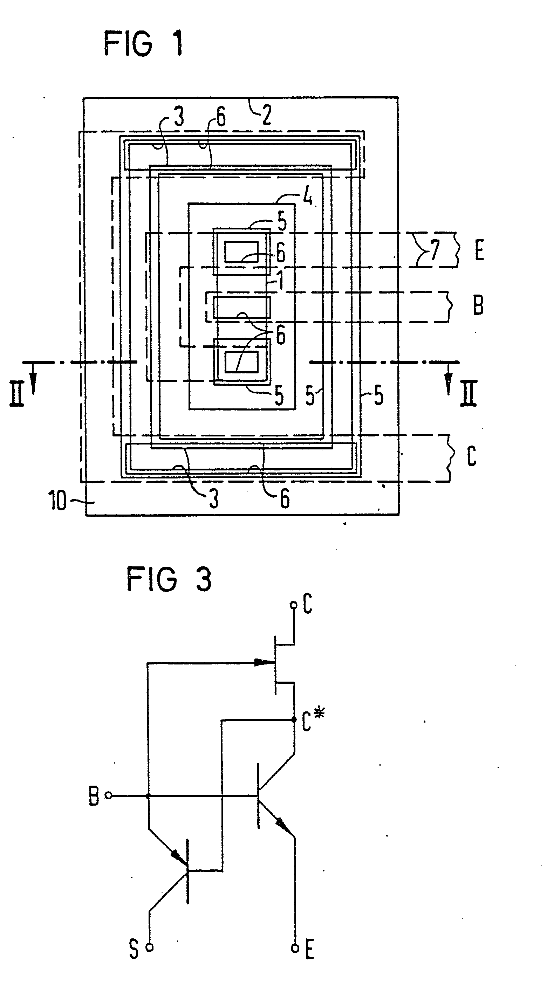

Bei der erfindungsgemäßen Transistoranordnung ist der Basisrand über den Rand des Buried layer hinausgezogen (vergleiche Fig. 1). Dadurch wird ein Injection-Feldeffekttransistor vom Verarmungstyp erzeugt, an dem der größte Teil der Kollektorspannung abfällt. Dabei ist die Basiszone des NPN-Transistors identisch mit der Gate-Elektrode des Junction-Feldeffekttransistors, während der Kollektorbereich unterhalb der Basiszone aber außerhalb des Buried layer dem Kanal des Junction-Feldeffekttransistors entspricht.

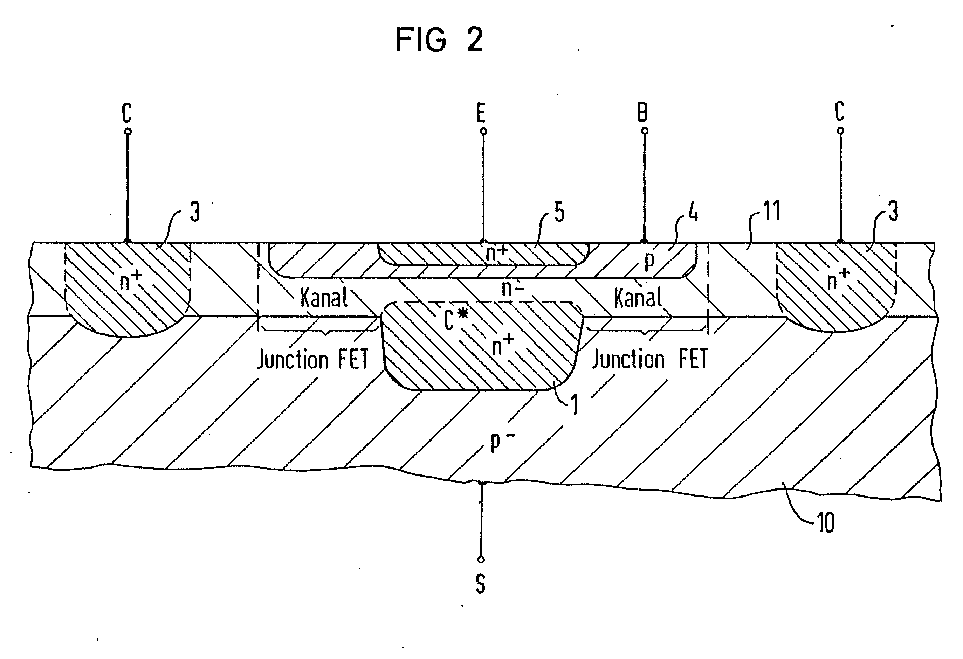

Bei dieser Transistoranordnung führt allerdings die Wirkung des Substrat-PNP-Transistors zu einem starken Absinken der an den äußeren Klemmen gemessenen Stromverstärkung, sobalt der innere NPN-Transistor (vergleiche die Klemmen C*, B, E in Fig. 2) in Sättigung kommt.

Die Ursache für die bereits bei kleinen Strömen einsetzende Sättigung der Transistorstruktur mit « verkleinertem » Buried layer ergibt sich aus dem Umstand, daß mit zunehmendem Kollektorstrom die effektive Steuerspannung (also die Potentialdifferenz zwischen C* und B) des Junction-Feldeffekttransistors kleiner wird beziehungsweise bei Beginn der Sättigung etwa den Wert + 0,7 V erreicht. Dabei wird der Wert des Kollektorstroms $I_{CS}$, oberhalb dem Sättigung auftritt, bei den gegebenen technologischen Parametern (Dicke der epitaktischen Schicht etwa 3 μm, Basiseindringtiefe etwa 0,8 μm, Dotierung der epitaktischen Schicht 7 · 10¹⁵ Atome/cm³) durch den Junction-Feldeffekttransistor bestimmt. Der Kollektorstrom $I_{CS}$ kann nur durch Erhöhung des Breiten/Längen-Verhältnisses des Kanals vergrößert werden (vergleiche auch A. S. Grove, « Physics and Technology of Semiconductor Devices », Wiley, New York, 1967).

Eine Weiterbildung der Erfindung besteht daher darin, daß zwischen dem schwach dotierten Substrat und der Kollektorzone ein stark dotierter Bereich (Buried layer) des gleichen Leitungstyps wie die Kollektorzone liegt, und daß zwischen der Basiszone und der Kollektoranschlußdiffusion ein Junction-Feldeffekttransistor vorgesehen ist, dessen Breiten/Längen-Verhältnis entsprechend dem zu verarbeitenden Strom ausgelegt ist.

Es handelt sich hier also um eine Serienschaltung eines Bipolartransistor und eines Junction-Feldeffekttransistors.

Zweckmäßigerweise ist vorgesehen, daß die Kollektoranschlußdiffusion beziehungsweise die Kollektortiefdiffusion die Basiszone im notwendigen Abstand umgibt.

Bei dieser Struktur liegt die Steuerelektrode auf dem Substratpotential und die Source-Elektrode des Junction-Feldeffekttransistors ist identisch mit dem Kollektor eines NPN-Transistors mit einem Buried layer. Durch diese Trennung von NPN-Transistor und Junction-Feldeffekttransistor ist es möglich, das Breiten/Längen-Verhältnis des Junction-Feldeffekttransistors entsprechend dem geforderten Strom auszulegen. Durch das Wegfallen des parasitären Substrat-PNP-Transistors fließen nur noch vernachlässigbar kleine Substratströme.

Für beide Strukturen ist dabei wesentlich, daß das für einen geforderten Strom notwendige Breiten/Längen-Verhältnis des Kanals des Junction-Feldeffekttransistors abhängig von den gewählten Technologie-Parametern (Dicke der epitaktischen Schicht, Dotierung der epitaktischen Schicht und Basiseindringtiefe) ist. Außerdem ist für das Funktionieren der erfindungsgemäßen Transistorstrukturen von Bedeutung, daß die Pinch-Spannung, also der Grenzwert zwischen dem Anlauf- und dem Sättigungsbereich des Junction-Feldeffekttransistors, kleiner als die Kollektor-Emitter-Abbruchspannung des inneren NPN-Transistors ist (EBC*).

Die mit den vorgeschlagenen Transistorstrukturen erreichte Kollektor-Emitter-Abbruchspannung ($U_{CEO}$) liegt um den Faktor 5 bis 10 höher als die der normalen npn-Transistoren. $U_{CEO}$ entspricht etwa der Abbruchspannung eines nichtgekrümmten Kollektor-Basis-Übergangs.

Nachfolgend wird die Erfindung an Hand der Zeichnungen näher erläutert. Es zeigen:

Figur 1 eine Draufsicht eines Ausführungsbeispiels der ersten erfindungsgemäßen Transistoranordnung,

Figur 2 einen Schnitt II-II der Transistoranordnung der Fig. 1,

Figur 3 ein Ersatzschaltbild der Transistoranordnung der Fig. 1,

Figur 4 die Abhängigkeit der Stromverstärkung vom Kollektorstrom bei einem herkömmlichen Transistor und einer Transistoranordnung nach der Fig. 1,

Figur 5 eine Draufsicht eines weiteren Ausführungsbeispiels der erfindungsgemäßen Transistoranordnung,

Figur 6 ein Ersatzschaltbild der Transistoranordnung der Fig. 5,

Figur 7 einen Schnitt B-B' von Fig. 5.

Fig. 1 zeigt eine Draufsicht eines Ausführungsbeispiels der erfindungsgemäßen Transistoranordnung, bei dem eine Basis 4 nur teilweise mit einem Buried layer 1 unterlegt ist, so daß an dieser Stelle ein lateraler Junction-Feldeffekttransistor wirksam wird. Ein Halbleiterkörper 10 ist auf seiner Oberfläche mit einer vorzugsweise aus Siliciumdioxid bestehenden Isolationsschicht bedeckt. Auf der Isolationsschicht sind Leitbahnen 7 aus Metall, vorzugsweise aus Aluminium, aufgebracht. Mit diesen Leitbahnen 7 werden die verschiedenen Transistorzonen E, B, C jeweils durch Kontaktfenster 6 in der Isolationsschicht angeschlossen. So ist der Emitteranschluß E über verschiedene Kontaktfenster 6 mit Emitterzonen 5 verbunden. Auch ist der Basisanschluß B über Kontaktfenster 6 mit der Basiszone 4 verbunden. Der Kollektoranschluß C ist schließlich ebenfalls über ein Kontaktfenster 6 an eine Kollektortief-Diffusionszone 3 angeschlossen.

Fig. 2 zeigt einen Schnitt II-II von Fig. 1. In dieser Figur sind die verschiedenen Metall-Leitbahnen 7 durch Anschlüsse C, E, B angedeutet. Wie aus dieser Figur ersichtlich ist, befindet sich eine stark $N^+$-dotierte Emitterzone 5 in einer P-dotierten Basiszone 4, die ihrerseits von einer schwach $n^-$-dotierten Kollektorzone 11 umgeben ist, deren elektrischer Anschluß über die Kollektortief-Diffusionszonen 3 erfolgt, die stark $n^+$-dotiert sind. Die Zonen 3, 4, 5 und 11 befinden sich auf einem vorzugsweise schwach $P^-$-dotierten Substrat. Zwischen dem p-dotierten Substrat 10 und der n-dotierten Kollektorzone 11 befindet sich unter einem Teil der Basiszone 4 eine stark n-dotierte Zone 1, der sogenannte Buried layer. Die Abmessungen und die Lage vom Buried layer 1 und von der Basiszone 4 sind so gewählt, daß entsprechend der Abbildung ein lateraler Junction-Feldeffekttransistor entsteht. Dabei bilden die Basiszone 4 und das Substrat 10 die Gate-Elektrode des Junction-Feldeffekttransistors. Das Kanalgebiet ist in der Fig. 2 ebenfalls bezeichnet.

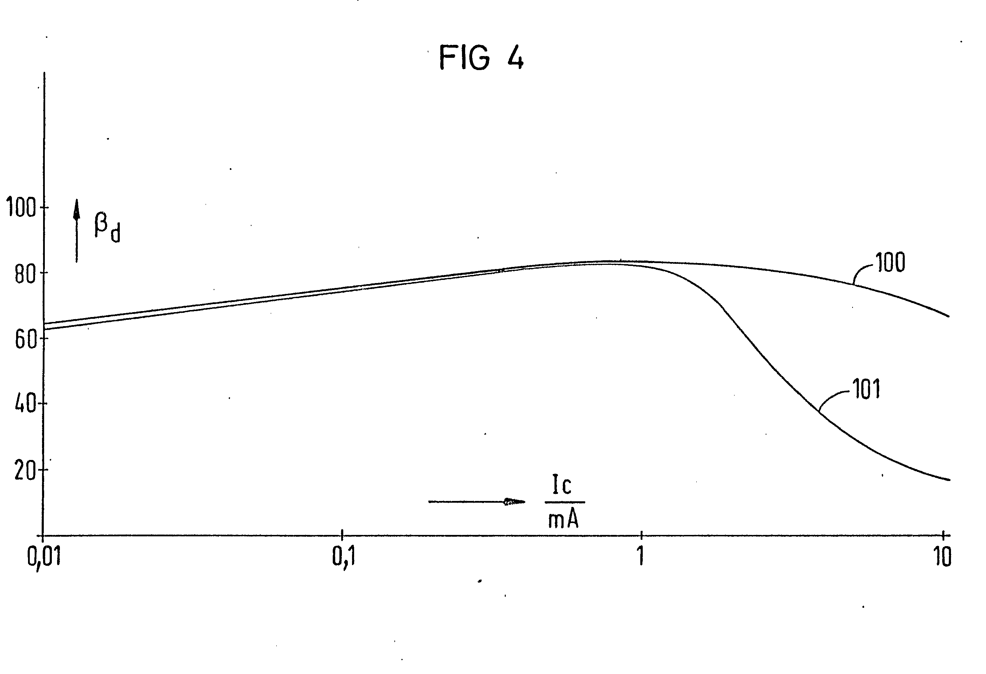

Fig. 3 zeigt ein Ersatzschaltbild zur Transistoranordnung nach den Fig. 1 und 2. Dabei sind einander entsprechende Bauteile mit den gleichen Bezugszeichen versehen. Wie aus Fig. 3 zu ersehen ist, liegt der Junction-Feldeffekttransistor zwischen dem Kollektoranschluß C und dem inneren Kollektor C* berziehungsweise der Zone 1. Die Gate-Elektrode des Junction-Feldeffekttransistors ist identisch mit dem Basisanschluß B, der seinerseits auch an den Emitter eines Substrat-PNP-Transistors angeschlossen ist, dessen Basis identisch mit dem Kanalgebiet des Junction-Feldeffekttransistors ist und dessen Kollektor am Substratanschluß S liegt.

Mit einer derartigen Transistorstruktur und den weiter oben genannten Technologieparametern kann eine Kollektor-Emitter-Durchbruchspannung $U_{CEO}$ zwischen 40 und 60 V erreicht werden. Dabei gilt $U_{CEO} = U'_{CBO}$.

In Fig. 4 ist die Stromverstärkung in Abhängigkeit vom Kollektorstrom für einen herkömmlichen Transistor mit Buried layer und für den in Fig. 1 gezeigten Transistor aufgetragen. Wie aus dieser Figur zu ersehen ist, nimmt die Stromverstärkung $\beta_d$ des Transistors gemäß Fig. 1 (Kurve 101) bei großen Strömen früher ab als die Stromverstärkung (Kurve 100) eines Standardtransistors mit normal ausgeführten Buried layer. Der Grund hierfür ist, daß der innere Transistor E, B, C* auf Grund des Spannungsabfalls am Junction-Feldeffekttransistor vorzeitig in Sättigung kommt, was ein Aktivieren des Substrat-PNP-Transistors zur Folge hat.

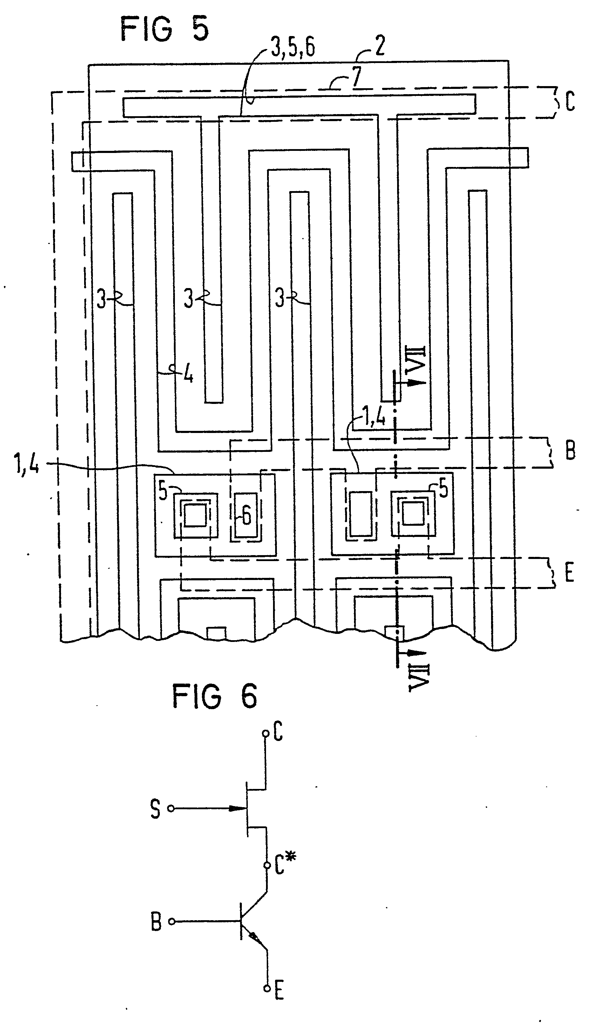

Fig. 5 zeigt ein weiteres Ausführungsbeispiel der erfindungsgemäßen Transistoranordnung in einer Draufsicht, wobei hier im Gegensatz zur Fig. 1 die Basis 4 vollständig mit einem Buried layer 1 unterlegt ist. Im übrigen sind in dieser Figur einander entsprechende Bauteile mit den gleichen Bezugszeichen versehen wie in Fig. 1. Mit der in Fig. 5 gezeigten Transistoranordnung kann bei gleicher Emitterfläche des Transistors ein erheblich größerer Strom gezogen werden, da hier die Möglichkeit besteht, das Breiten/Längen-Verhältnis des Junction-Feldeffekttransistors an den vom NPN-Transistor (E, B, C*) lieferbaren Strom anzupassen. Die Kollektor-Emitter-Durchbruchsspannung $U_{CEO}$ liegt bei dieser Struktur ebenfalls im Bereich 40 bis 60 V.

Wie aus der Fig. 5 zu ersehen ist, verwendet dieses Ausführungsbeispiel sogenannte Kollektortieffinger, um so einen Junction-Feldeffekttransistor mit niedrigen Bahnwiderständen zu bilden, dessen Kanal-Breiten/Längen-Verhältnis entsprechend dem zu verarbeitenden Strom ausgelegt ist.

Fig. 6 zeigt das Ersatzschaltbild für das Ausführungsbeispiel der Fig. 5. Hier liegen also der Junction-Feldeffekttransistor und der Bipolartransistor in Reihe zueinander und sind über den Punkt C* miteinander verbunden.

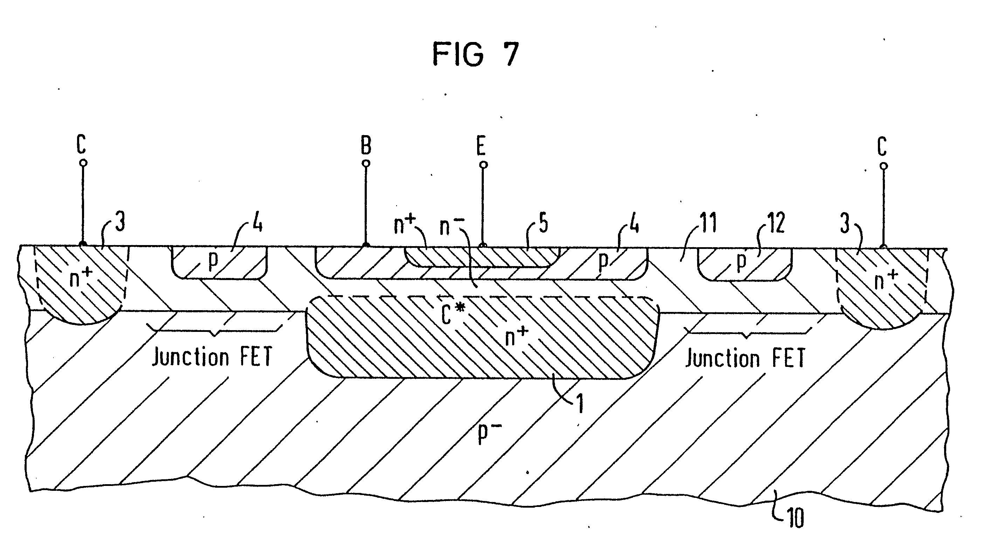

Fig. 7 zeigt einen Schnitt B-B' der Struktur in Fig. 5. Die Gate-Elektrode 12 ist von der Basis 4 abgetrennt und elektrisch mit dem Substrat verbunden. Dadurch kann der parasitäre Substrat-PNP-Transistor nicht mehr wirksam werden, was einen entsprechenden Substratstrom verhindert.

**Patentansprüche**

1. Transistoranordnung mit hoher Kollektor-Emitter-Durchbruchsspannung, bei der eine stark dotierte Emitterzone (5) des ersten Leitungstyps in einer schwächer dotierten Basiszone (4) des zweiten Leitungstyps eingebettet ist, mit einer noch schwächer dotierten Kollektorzone (11) des ersten Leitungstyps, in die die Basiszone (4) eingebettet ist, mit einem an die Kollektorzone angrenzenden schwach dotierten Substrat (10) von zweiten Leitungstyp, mit einem Kollektorkontaktbereich (3), der höher dotiert ist als die Kollektorzone (11), und mit einer unter dem Bereich der Basiszone (4) liegenden vergrabenen Schicht (buried layer) (1) zwischen dem Substrat (10) und der Kollektorzone (11), die gleichen Leitungstyp hat wie die Kollektorzone, jedoch eine stärkere Dotierung aufweist, dadurch gekennzeichnet, daß zwischen der vergrabenen Schicht (1) und dem Kollektorkontaktbereich (3) ein Junction-FET liegt, der mit dem bipolaren Transistor eine Serienschaltung bildet.

2. Transistoranordnung nach Anspruch 1, dadurch gekennzeichnet, daß der Kollektorkontaktbereich (3) die Basiszone (4) in einem vorgegebenen Abstand umgibt.

3. Transistoranordnung nach Anspruch 1, dadurch gekennzeichnet, daß der Rand der Basiszone (4) über den Bereich der vergrabenen Schicht (1) hinausgezogen ist.

4. Transistoranordnung nach Anspruch 1, dadurch gekennzeichnet, daß der Bereich der Basiszone (4) vollständig von der vergrabenen Schicht (1) unterlegt ist.

**Claims**

1. A transistor arrangement having a high collector-emitter breakdown voltage, in which a highly doped emitter zone (5) of the first conductivity type is embedded in a more weakly doped base zone (4) of the second conductivity type, the transistor arrangement having an even more weakly doped collector zone (11) of the first conductivity type into which the base zone (4) is embedded, a weakly doped substrate (10) of the second conductivity type which adjoins the collector zone, a collector contact zone (3) which is more highly doped than the collector zone (11), and a buried layer (1) which is located between the substrate (10) and the collector zone (11) beneath the region of the base zone (4) and which has the same conductivity type as the collector zone but is more strongly doped, characterized in that between the buried layer (1) and the collector contact zone (3), there is arranged a FET-junction which forms a series arrangement with the bipolar transistor.

2. A transistor arrangement as claimed in Claim 1, characterised in that the collector contact zone (3) surrounds the base zone (4) at a predetermined spacing.

3. A transistor arrangement as claimed in Claim 1, characterised in that the edge of the base zone (4) extends beyond the region of the buried layer (1).

4. A transistor arrangement as claimed in Claim 1, characterised in that the buried layer (1) completely underlies the region of the base zone (4).

**Revendications**

1. Dispositif à fonctionnement en transistor comportant une tension élevée de claquage collecteur-émetteur, dans lequel une zone d'émetteur (5) fortement dopée et possédant le premier type de conductivité est insérée dans une zone de base (4) plus faiblement dopée et possédant le second type de conductivité, et comportant une zone de collecteur (11) encore plus faiblement dopée et possédant le premier type de conductivité et dans laquelle la zone de base (4) est insérée, un substrat (10) faiblement dopé, possédant le second type de conductivité et jouxtant la zone du collecteur, une région (3) de contact de collecteur, qui est plus fortement dopée que la zone de collecteur (11), et une couche (buried layer) (1) ensevelie au-dessous de la région de la zone de base (4), entre le substrat (10) et la zone de collecteur (11) et qui possède le même type de conductivité que la zone de collecteur, mais possède un dopage plus intense, caractérisé par le fait qu'un transistor à effet de champ à jonction, qui forme avec le transistor bipolaire un circuit série, est disposé entre la couche ensevelie (1) et la région (3) du contact de collecteur.

2. Dispositif à fonctionnement en transistor suivant la revendication 1, caractérisé par le fait que la région (3) du contact de collecteur entoure la zone de base (4) à une distance prédéterminée.

3. Dispositif à fonctionnement en transistor suivant la revendication 1, caractérisé par le fait que le bord de la zone de base (4) s'étend au-delà de la région de la couche ensevelie (1).

4. Dispositif à fonctionnement en transistor suivant la revendication 1, caractérisé par le fait que la couche ensevelie (1) s'étend au-dessous de l'ensemble de la région de la zone de base (4).

FIG 1

FIG 3

FIG 2

FIG 4

## FIG 5

## FIG 6

FIG 7

0 045 447